# EUROPEAN PATENT APPLICATION

(11) **EP 2 216 812 A1**
(43) Date of publication of application: **11.08.2010**
(21) Application number: 08853985.3
(22) Date of filing: 20.11.2008
(51) Int. Cl.: H01L 23/427, F28D 15/02, H05K 7/20

(54) **EBULLIENT COOLING UNIT**

(30) Priority: 28.11.2007 JP 2007307796
(71) Applicant: Kabushiki Kaisha Toyota Jidoshokki, Kariya-shi Aichi 448-8671 (JP)
(72) Inventor: HARIU, Satoshi, Kariya-shi Aichi 448-8671 (JP)
(74) Representative: TBK-Patent
(86) International application number: PCT/JP2008/071106
(87) International publication number: WO 2009/069527

(57) **Abstract**

To provide an ebullient cooling device that can maintain favorable cooling-medium circulation.

An ebullient cooling device according to the present invention is **characterized in that** it is an ebullient cooling device that includes a heat receiving unit 21 to which a heating element "Z" is installed, and which has a cooling medium in the inside, a condensing unit 22 which communicates with the heat receiving unit 22, and which condenses the cooling medium that has been boiled by means of heat resulting from the heating element "Z," a cooling-medium circulating unit 23 which communicates with the heat receiving unit 21 and condensing unit 22, into which the cooling medium having been condensed at the condensing unit 22 flows and additionally which supplies the cooling medium to the heat receiving unit 21, and an inner bottom face 22b of the condensing unit 22 includes a guiding portion which guides the cooling medium to the cooling-medium circulating unit 23 by means of gravity.

## Description

### TECHNICAL FIELD

The present invention is one which relates to an ebullient cooling device that uses a cooling medium.

### BACKGROUND ART

An ebullient cooling device is a device for cooling a heating element utilizing the natural convection of cooling medium. For example, an ebullient cooling device disclosed in Japanese Unexamined Patent Publication (KOKAI) Gazette No. 2003-42,672 (Patent Literature No. 1) is equipped with a cooling-medium container which stores a cooling medium in the inside and to one of whose opposite surfaces a heating element is to be installed, and a heat-radiating unit which is assembled to the other one of the opposite surfaces of the cooling-medium container. Further, this ebullient cooling device is equipped with a barrier that divides the inside of the cooling-medium container into a heating-element-side flow passage and a heat-radiating-unit-side flow passage. On the premise that the ebullient cooling device is made use of in such a state that the both opposite surfaces of the cooling-medium container are upright, it materializes favorable cooling-medium circulation.
Patent Literature No. 1: Japanese Unexamined Patent Publication (KOKAI) Gazette No. 2003-42,672

### DISCLOSURE OF THE INVENTION

### Assignment to be Solved by the Invention

However, in the aforementioned ebullient cooling device, there might be such a fear that the cooling-medium circulation has been retarded because the cooling medium (or condensed liquid), which has been condensed at the heat-radiating unit, is gathered onto the bottom face of the heat-radiating unit by means of gravity.

Moreover, in actuality, however, it is not necessarily the case that the ebullient cooling device is always in the upright state, because of being mounted on all sorts of instruments and apparatuses. Especially, in the case of being mounted on a vehicle, when the vehicle is on a sloping road, and the like, for instance, the ebullient cooling device is likely to be put in a state of being inclined from the upright state for a long period of time. In this case, there might be such a fear that no favorable cooling-medium circulation can be maintained in the aforementioned ebullient cooling device.

For example, in the case where the aforementioned ebullient cooling device is maintained in such a stage of being inclined to the side of the other one of the opposite surfaces, the cooling medium, which has been condensed at the heat-radiating unit, flows to the leading-end side of the heat-radiating unit by means of gravity, and then becomes less likely to flow back to the heat-radiating-unit-side flow passage circularly. As a result, it might have become impossible to maintain favorable cooling-medium circulation. When the condensed liquid is not supplied to the heating-element-side flow passage by way of the heat-radiating-unit-side flow passage, the cooling of the heating element might become insufficient, and that might have possibly become the cause of burnout.

The present invention is one which has been done in view of such circumstances, and it is an object to provide an ebullient cooling device that can maintain favorable cooling-medium circulation.

### Means for Solving the Assignment

An ebullient cooling device according to the present invention is **characterized in that** it is an ebullient cooling device comprising:
a heat receiving unit to which a heating element is installed, and inside of which a cooling medium is accommodated;
a condensing unit which lies successively to the heat receiving unit, and inside of which a heat exchanger is accommodated, the heat exchanger being for condensing the cooling medium that has been boiled by means of heat resulting from the heating element;
a cooling-medium circulating unit which lies successively to the heat receiving unit and to the condensing unit, and which returns the cooling medium having been condensed at the condensing unit back to the heat receiving unit; and
an inner bottom face of the condensing unit comprising a guiding portion which inclines downward, and which guides the cooling medium having been condensed at the heat exchanger to the cooling-medium circulating unit.

The cooling medium (or condensed liquid), which has been condensed at the heat exchanger, drops to the inner bottom face of the condensing unit by means of gravity. The guiding portion, which is disposed on the inner bottom face of the condensing unit, inclines downward, and thereby guides the cooling medium to the cooling-medium circulating unit utilizing gravity. The condensed liquid that has dropped to the bottom face of the condensing unit, and the cooling medium (or liquid reservoir) that is has been gathered in the condensing unit are guided to the cooling-medium circulating unit by means of the guiding portion that inclines downward. That is, the cooling medium, which is present on the bottom face of the condensing unit, becomes likely to flow into the cooling-medium circulating unit. Thus, the condensed liquid, and the reserved liquid become less likely to be retarded inside the condensing unit, thereby making it possible to materialize favorable cooling-medium circulation.

Here, it is preferable that the guiding portion can be an inclining face that inclines so as to be headed downward as it goes toward the cooling-medium circulating unit. In accordance with this setting, the coolingmedium (or condensed liquid or liquid reservoir), which is present on the guiding portion, receives a force in the direction of being headed to the cooling-medium circulating unit by means of gravity. That is, the aforesaid cooling-medium is guided so as to flow from the condensing unit toward the cooling-medium circulating unit by means of the guiding portion.

Moreover, it is possible to suppress the increment of production cost, because the guiding portion can be formed readily. In addition, even when the ebullient cooling device inclines, it is possible to cancel the inclination of the ebullient cooling device to the extent that the guiding portion inclines, thereby making it possible to prevent the occurrence of unnecessary liquid reservoir. Therefore, even if the ebullient cooling device inclines, it becomes feasible to maintain favorable cooling-medium circulation. Note that it is allowable that the guiding portion can even be a groove that inclines toward the cooling-medium circulating unit.

Here, it is preferable that the condensing unit can have an inner bottom face whose entire face is the guiding portion. Thus, the cooling medium, which has been condensed at the heat exchanger and then drops onto the bottom face, is guided to the cooling-medium circulating unit as a whole. Therefore, no liquid reservoir, which does not contribute to cooling-medium circulation, can arise on the bottom face of the condensing unit, thereby making it possible to materialize more favorable cooling-medium circulation. For example, it is preferable that the inner bottom face of the condensing unit can be an inclining face that inclines to be headed downward as it goes toward cooling-medium circulating unit. In accordance with this setting, even when the ebullient cooling device inclines furthermore, the inclination can be canceled because the inner bottom face's entire face is the inclining face, and the occurrence of unnecessary liquid reservoir can be prevented highly accurately, thereby making it possible to maintain more favorable cooling-medium circulation.

Here, it is preferable that the heat exchanger canbe disposed above the inner bottom face of the condensing unit and above the cooling-medium circulating unit. The heat exchanger can be, for instance, a condenser pipe and the like having a plurality of pipes, and accordingly the cooling medium is flowing within the pipes.

When the heat exchanger is present above the inner bottom face of the condensing unit alone, the cooling medium (or condensed liquid), which has been condensed at the heat exchanger, drops onto the inner bottom face of the condensing unit by means gravity. This implies that the condensed liquid comes to pass the condensing unit via the bottom face temporarily and then flow into the cooling-medium circulating unit in circulating the cooling medium. That is, it does not turn into direct cooling-medium circulation, and consequently there is a fear that temporal loss might occur.

On the other hand, when the entire heat exchanger is disposed above the cooling-medium circulating unit, the condensed liquid is likely to flow into the cooling-medium circulating unit directly. However, since it is often the case that the heat receiving unit and the cooling-medium circulating unit are disposed to neighbor each other constructionally, the condensed liquid has become likely to flow into the heat receiving unit if the ebullient cooling device has inclined. That is, there might be a fear of hampering favorable cooling-medium circulation.

Hence, it is possible to drop the condensed liquid, which has been condensed at a part of the heat exchanger, to the cooling-medium circulating unit directly by disposing the aforesaid part above the cooling-medium circulating unit. And, since it is not the case that the entire heat exchanger is disposed above the cooling-mediumcirculatingunit, it is possible for the heat exchanger to keep a certain extent of distance with respect to the heat receiving unit. Therefore, even if the device has inclined, it is feasible to make the condensed liquid less likely to flow backward to the heat receiving unit. That is, it is possible to reduce temporal loss, and it is possible to prevent the backward flow if having been inclined.

Here, it is preferable that the heat receiving unit can have a deflector plate which not only marks off between the heat receiving unit per se and the cooling-medium circulating unit but also deflects the cooling medium having been boiled toward the heat exchanger. Thus, vapors of the cooling medium that has been boiled become likely to hit against the heat exchanger, and thereby it is possible to condense the cooling-medium vapors efficiently. That is, more favorable cooling-medium circulation becomes feasible.

### Effect of the Invention

In accordance with the ebullient cooling device according to the present invention, it is possible to maintain favorable cooling-medium circulation.

### BRIEF DESCRIPTION OF THE DRAWING

Fig. 1 is a schematic perspective diagram of an ebullient cooling device 1 in an instant embodiment; and
Fig. 2 is a schematic cross-sectional diagrambeing taken in the direction of arrowheaded lines "A"-"A" in Fig. 1.

### Explanation on Reference Numerals

- 1:: Ebullient Cooling Device;
- 2:: Cooling-medium Container; 21: Heat Receiving Unit; 21a: Outer Surface; 21b: Deflector Plate; 22: Condensing Unit;
- 22a:: Protrusion Region; 22b: Bottom Face;
- 23:: Cooling-medium Circulating Unit;
- 3:: Piped Condensing Unit; 31: Assembly; and
- "Z":: Heating Element

### BEST MODE FOR CARRYING OUT THE INVENTION

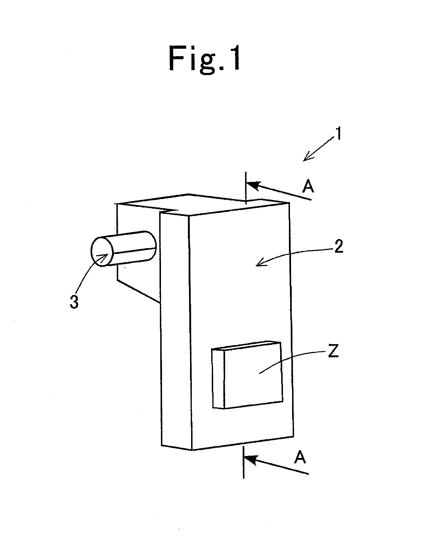

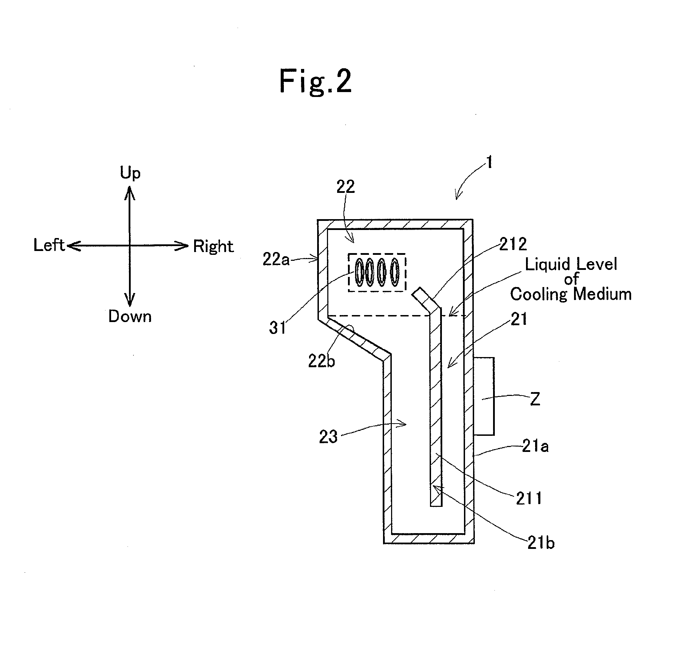

Next, the present invention will be explained in more detail while giving an embodiment. In the present embodiment, an ebullient cooling device 1 that is to be mounted on a vehicle is given as an example. Hereinafter, explanations will be made on the ebullient cooling device 1 with reference to Fig. 1 and Fig. 2. Fig. 1 is a schematic perspective diagram of the ebullient cooling device 1 in the present embodiment. Fig. 2 is a schematic cross-sectional diagram being taken in the direction of arrowheaded lines "A"-"A" in Fig. 1.

As illustrated in Fig. 1, the ebullient cooling device 1 is equipped with a cooling-medium container 2, and a piped condensing unit 3. The cooling-medium container 2 is made of metal; as shown in Fig. 2, the cross section is a substantially letter-"L" shape; and a cooling medium (one of chlorofluorocarbons, for instance) is stored in the interior. The cooling-medium container 2 comprises a heat receiving unit 21, a condensing unit 22, and a cooling-medium circulating unit 23. In general, the cooling medium circulates in the following manner. Specifically, vapors of the cooling medium, which receives heat from a heating element "Z" in the heat receiving unit 21 to boil, is condensed at the condensing unit 22; the resulting condensed liquid flows into the cooling-medium circulating unit 23; and then the cooling-medium circulating unit 23 returns the cooling medium back to the heat receiving unit 21.

As illustrated in Fig. 2, the heat receiving unit 21 is roughly a region, which is surrounded by side faces (or four faces) that include an outer surface 21a and a deflector plate 21b, in the present embodiment. The heating element "Z" is installed to the outer surface 21a of the heat receiving unit 21a. The heating element "Z" is a semiconductor element and the like, for instance.

Here, the state shown in Fig. 2 is labeled an upright state. That is, the outer face 21a becomes perpendicular with respect to a horizontal plane. Note that the installed position of the heating element "Z" becomes more upward than the bottom face of the cooling-medium container 2 is. Hereinafter, explanations will be made based on the upright state illustrated in Fig. 2.

The deflector plate 21b, which is disposed inside the cooling-medium container 2, forms a side face of the heat receiving unit 21, and divides the inner space of the cooling-medium container 2 into the heat receiving unit 21 and the cooling-medium circulating unit 23. The deflector plate 21b will be described later. The heat receiving unit 21 receives the heat resulting from the heating element "Z," and the cooling medium inside the heat receiving unit 21 boils because of that heat. The resultant boiling cooling-medium vapors rise, and then go into the condensing unit 22. The condensing unit 22 will be described later.

The cooling-medium circulating unit 23 is one of the opposite sides that are divided by the deflector plate 21b inside the cooling-medium container 2, and is positioned on the opposite side to the outer surface 21a. The cooling-medium circulating unit 23 lies successively to the heat receiving unit 21, and is put in place parallelly to it. The interior of the cooling-medium circulating unit 23 communicates with the interior of the heat receiving unit 21 on the lower side. In accordance with this setting, when the liquid level in the heat receiving unit 21 falls by boiling, the cooling medium inside the cooling-medium circulating unit 23 is supplied to the heat receiving unit 21 by pressure difference.

The condensing unit 22 is present above the cooling-medium circulating unit 23, and protrudes from the upper side of the cooling-medium circulating unit 23 toward the opposite side to the outer surface 21a (or to the left in Fig. 2). In Fig. 2, the interior of the condensing unit 22 communicates with the interior of the heat receiving unit 21 on the right, and communicates with the interior of the cooling-medium circulating unit 23 on the lower side. In the present embodiment, the inner bottom face 22b of the condensing unit 22 is the lower-face inner side in the aforementioned protruded region 22a (hereinafter referred to as a "protrusion region 22a").

This protrusion region 22a functions as a liquid reservoir for urging the cooling-medium circulation from the cooling-medium circulating unit 23 to the heat receiving unit 21. That is, the cooling-medium supply from the cooling-medium circulating unit 23 to the heat receiving unit 21 is facilitated by means of gravitation by filling the cooling medium, which is stored in advance, up to the lower bottom of the protrusion region 22a (or raising the liquid level). The condensing unit 22 of the present embodiment has a condensation function, and a liquid-reservoir function.

And, the lower face of the protrusion region 22a, namely, the inner bottom face 22b of the condensing unit 22, is formed in such a tapered shape (or inclined face) that the more it is headed for the cooling-medium circulating unit 23 (or is headed for the right) the more it is headed for the lower side. In accordance with this setting, the cooling medium present on the inner bottom face 22b of the condensing unit 22 is guided naturally to the cooling-medium circulating unit 23 (or to the lower right) by means of gravity. Specifically, the entire face of the condensing unit 22' s inner bottom face 22b functions as the guiding portion in the present invention, and thereby the cooling-medium circulation becomes favorable. In the present embodiment, the inclination angle of the inner bottom face 22b with respect to the horizontal plane is 45 degrees roughly.

The piped condensing unit 3 penetrates through the condensing unit 22, and is constituted of an assembly 31 of a plurality of flattened tubes (being equivalent to the "heat exchanger" in the present invention) at the region that is located inside the condensing unit 22. The cooling medium flows through the interior of the piped condensing unit 3, and the cooling medium (e.g., coolant water, and the like) flows inside the respective flattened tubes by way of a not-shown header. That is, the assembly 31 is accommodated in the condensing unit 22, and condenses the vapors of the cooling medium that has boiled at the heat receiving unit 21.

The assembly 31 is located above the inner bottom face 22b of the condensing unit 22 and above the cooling-medium circulating unit 23 within the cooling-medium container 2. The cooling medium, which has been condensed at the assembly 31, flows onto the inner bottom face 22b of the condensing unit 22, or flows directly into the cooling-medium circulating unit 23, because it is headed downward by means of gravity.

In accordance with this setting, the cooling medium that has been condensed at the condensing unit 22 flows to fall down onto the inner bottom face 22b that functions as the guiding portion, or into the cooling-medium circulating unit 23. The cooling medium that has been condensed above the inner bottom face 22b flows to fall down toward the inner bottom surface 22b, and is then guided to the cooling-medium circulating unit 23 after it has dropped on the inner bottom face 22b, or flows to and then joins with the liquid reservoir that has been stored on the inner bottom face 22b in advance.

In the case of former (that is, in the case of having fallen down onto the inner bottom face 22b), the cooling medium is not retarded at all so that it is possible to materialize favorable cooling-medium circulation, because the cooling medium (or condensed liquid) flows into the cooling-medium circulating unit 23 along the inclination. Even in the case of latter (that is, in the case of joining with liquid reservoir), the cooling medium in the liquid reservoir is likely to flow into the cooling-medium circulating unit 23 so that favorable cooling-medium circulation can be maintained, because the liquid reservoir itself is present on the inner bottom face 22b that makes the guiding portion. In accordance with the present embodiment, the cooling-medium circulation becomes favorable because the inner bottom face 22b of the condensing unit 22 is a tapered shape.

Moreover, even when the ebullient cooling device 1 inclines to the left in Fig. 2, an independent liquid reservoir of the cooling medium is prevented from occurring at the leading end (or left end) of the condensing unit 22 to such an extent that the inner bottom face 22b inclines to the lower right. That is, it is possible to prevent the occurrence of liquid reservoir that does not contribute to cooling-medium circulation, and accordingly it is possible to maintain favorable liquid-medium circulation even when the ebullient cooling device 1 inclines to the left. Moreover, when the ebullient cooling device 1 inclines to the right, the inclination of the inner bottom face 22b becomes steeper. In this instance, there is such a possibility that the cooling medium, which has been condensed at the assembly 31, might flow into the heat receiving unit 21.

However, in the present embodiment, it is possible to provide a distance of separation between the heat receiving unit 21 and the assembly 31 sufficiently, because all of the assembly 31 is not put in place above the cooling-medium circulating unit 23 but a part of the assembly 31 is disposed so as to be located above the cooling-medium circulating unit 23. That is, it is possible to inhibit the condensed liquid from flowing into the heat receiving unit 21 from above the heat receiving unit 21.

Moreover, although being detailed later, the leading end of the deflector plate 21b inclines leftward. Therefore, when the ebullient cooling device 1 inclines to the right, the rising cooling-medium vapors become more likely to hit against the assembly 31, and thereby the condensation is facilitated. Specifically, even when the ebullient cooling device 1 inclines to the right, it is possible to maintain favorable cooling-medium circulation.

In addition, it is possible to make the volume (or size of protrusion) of the protrusion region 22a smaller. That is, downsizing the ebullient cooling device 1 becomes feasible, too.

The ebullient cooling device 1 is to be mounted on a vehicle, and the mounting direction is as follows: the left in Fig. 2 is the vehicular front (or vehicular rear); and the right therein is the vehicular rear (or vehicular front). The vehicle inclines when being present on sloping roads, for instance. That is, the vehicle inclines forward or rearward, and then the ebullient cooling device 1 that is mounted on that vehicle inclines leftward or rightward in Fig. 2. Specifically, since the ebullient cooling device 1 according to the present embodiment can maintain favorable cooling-medium circulation even upon inclining leftward or rightward, it is suitable for mounting on vehicles.

Hereinafter, the deflector plate 21b will be explained. The deflector plate 21b is formed as a plate shape, and comprises a partition section 211 that extends parallelly to the outer surface 21a, and a deflected section 212 that elongates from the upper end of the partition portion 211 toward the assembly 31. In the present embodiment, the elongating direction of the deflected section 212 is such a direction that the distance between the upper end of the partition section 211 and the assembly 31 becomes the shortest. In accordance with this setting, the cooling-medium vapors become likely to be headed for the assembly 31, thereby making it possible to have the cooling-medium vapors hit against the assembly 31 efficiently. Note that it is possible to obtain the advantageous effect as far as the elongating direction of the deflector section 212 is headed for the disposition side of the assembly 31.

Moreover, the liquid level of the cooling medium that is stored in the cooling-medium container 2 in advance is present at around the top of the inner bottom face 22b of the condensing unit 22 as shown in Fig. 2, and accordingly the condensing unit 22 functions as a liquid reservoir. And, the deflector plate 21b is set up so that the upper end is above the aforesaid liquid level in the upright condition. In accordance with this setting, it is possible to inhibit the advancement of the cooling-medium vapors that has boiled at the heat receiving unit 21 and the return of the condensed liquid that has been condensed at the condensing unit 22 from becoming obstacles to each other. That is, not only the cooling-medium vapors are kept from hindering the return of the condensed liquid, but also the condensed liquid is kept from going into the passage for the cooling-medium vapors (or the heat receiving unit 21).

As described above, in accordance with the ebullient cooling device 1, it is possible to maintain favorable cooling-medium circulation. Note that it is also allowable that the inner bottom face 22b of the condensing unit 22 can be equipped with a railed groove that inclines toward the cooling-medium circulating unit 23, for instance, as the other guiding portion. Moreover, it is permissible as well that a guiding,portion can be those which incline three-dimensionally, such as trumpets' inner face and chutes.

Moreover, it is also allowable to make such a construction that the heating element "Z" is put in place within the heat receiving unit 21 (or an immersion system). For example, it is permissible as well to install the heating element "Z" on an inner-side face that corresponds to the outer surface 21a so as to soak the heating element "Z" in the cooling medium. Even in this case, it is possible to obtain the same advantageous effects as described above. Note that it is preferable to use an insulative cooling medium when the heating element "Z" is an electronic component like a semiconductor element.

## Claims

1. An ebullient cooling device being **characterized in that** it is an ebullient cooling device comprising:
a heat receiving unit to which a heating element is installed, and inside of which a cooling medium is accommodated;
a condensing unit which lies successively to said heat receiving unit, and inside of which a heat exchanger is accommodated, the heat exchanger being for condensing said cooling medium that has been boiled by means of heat resulting from said heating element;
a cooling-medium circulating unit which lies successively to said heat receiving unit and to said condensing unit, and which returns said cooling medium having been condensed at said condensing unit back to said heat receiving unit; and
an inner bottom face of said condensing unit comprising a guiding portion which inclines downward, and which guides said coo ling medium having been condensed at said heat exchanger to said cooling-medium circulating unit.

2. The ebullient cooling device as set forth in claim 1, wherein said guiding portion is an inclining face that inclines so as to be headed downward as it goes toward said cooling-medium circulating unit.

3. The ebullient cooling device as set forth in claim 1 or 2, wherein said condensing unit has an inner bottom face whose entire face is said guiding portion.

4. The ebullient cooling device as set forth in either one of claims 1 through 3, wherein said heat exchanger is disposed above the inner bottom face of said condensing unit and above said cooling-medium circulating unit.

5. The ebullient cooling device as set forth in either one of claims 1 through 4, wherein said heat receiving unit has a deflector plate which not only marks off between the heat receiving unit per se and said cooling-medium circulating unit but also deflects said cooling medium having been boiled toward said heat exchanger.
